# EUROPEAN PATENT APPLICATION

(11) **EP 2 700 957 A1**
(43) Date of publication of application: **26.02.2014**
(21) Application number: 13003984.5
(22) Date of filing: 09.08.2013
(51) Int. Cl.: G01R 15/24, G01R 15/22

(54) **Optical device for generating a synchronous signal**

(30) Priority: 21.08.2012 IT MI20121435
(71) Applicant: Ricerca Sul Sistema Energetico - RSE S.p.A., 20134 Milano (IT)
(72) Inventor: Bartalesi, Daniele, 20134 Milano (IT); De Maria, Letizia, 20134 Milano (IT); Pistoni, Natale Claudio, 20134 Milano (IT); Serragli, Paolo, 20134 Milano (IT)
(74) Representative: Ferraiolo, Ruggero

(57) **Abstract**

An electro-optical transducer (T ) is suitable to generate an optical signal having the same frequency and phase of the voltage of the electric network, the signal being synchronous with the voltage of a predetermined phase in a remote control board or in a remote electric cabin of an electric network (Fig. 1).

## Description

The present invention relates to a device suitable for generating a signal synchronous with the voltage of one phase of an electric network in order to continuously monitor, for example in a control room, the phase and frequency of the network voltage in an electric board or in an electrical cabin in which the divice is installed. In particular, the device, which comprises an electro-optical transducer inserted inside one of the three light signaling modules for the presence of phase (there will be a transducer for each of the electrical phases of the electrical network), is connected with the network voltage and is suitable for being mounted inside a luminous indicator of electric voltage presence or directly on a capacitive divider inside an electric board.

It is understood that the invented device is used conveniently in the general structure of a "smart grid" in order to obtain real-time information about the proper operation of an electric component, such as an operation compartment for isolators, in particular if the device belongs to a medium voltage electric net in a distribution cabin.

Said synchronous signal means, in this context, an optical signal that has the same frequency of, and has a definite correlation of phase with the voltage of the electric netwok arriving at a remote control board or a remote electric cabin to be monitored as well as the term - remote - means a location, an electric board, an electric cabin, an electric or electromechanical apparatus far away from the place where the synchronism signal is received, place that can be called - control room -.

### State of the art.

According to the state of the art, on the electric boards of medium voltage (MV) capacitor dividers are used associated with luminous indicators (typically a neon lamp or a LED) that detect the presence of voltage on the phases of an electrical circuit by visual inspection on place.

Also apparatuses are known that comprise voltage meters and electric circuitry capable of reconstructing a signal at the frequency of the network voltage and coupled to each electric phase of the electric component with which the meter is connected.

Finally, electro-optical devices are known which measure the voltage of the network and allow to obtain the values of the frequency and phase, as disclosed by the document U.S. N ° 5,153,427.

### Drawbacks of the state of the art.

A limit of the luminous indicators is not to provide information enough to get a synchronism signal; such indicators provide, in fact, only an approximate value of the voltage on each electric phase of the electric circuit; in addition, they do not allow to remotely transmit the signal generated.

The known apparatuses mentioned above, based on voltage meters and electric circuitry, are bulky and have a low galvanic isolation, so they are potentially subject to disturbances and/or electromagnetic interferences.

The known electro-optical devices are used to measure the voltage of alternating currents, but not specifically for generating a signal synchronous with the network voltage in MV boards. Moreover, they are of complex composition and rather expensive due to the need to employ special fibers, polarizing elements, etc.

### Purpose of the invention.

The general object of the invention is to provide a device sensitive to the amplitude of the voltage of the electric network and its time course, and also to provide a device suitable to be mounted inside a luminous indicator (or light indicator) that signals the presence of voltage or directly on a capacitive divider inside an electric board.

It is understood that, for instance, in a three-phase electric system, three devices will be installed within the electric board or the electric cabin.

### In particular:

- A first aim is to detect the voltage value of a phase of the electric network and transduce said value in an optical signal made suitable to generate a synchronism signal: a suitable remote processor of the optical signal allows to generate the said synchronism signal, in other words a signal having the same frequency and phase of the voltage of the electric network in an electric board or in an electric cabin, but with features suitable to be directly used in a system of digital type for acquiring data.
- A second aim is to ensure a high galvanic isolation in transmitting at a distance, by means of an optical fiber, the optical signal generated.
- Another aim is to measure and control the operation of remote equipments in the electric network, such as, for instance:
   i) measure in a control room the phase of the network voltage and its periodicity;
   ii)control in a control room the presence of voltage and its value in an electric phase and control the distortions as to the value and periodicity of the rated voltage and also providing a control of the network voltage amplitude.

### Disclosure of the invention.

The present invention relates to a device that, intended to be installed in a remote electric board or in a remote electric cabin, primary or secondary one, comprises means suitable for generating an optical signal synchronous with the voltage of the electric network in electrical components in order to continuously monitor in a control room the voltage and frequency of a predetermined phase of the power netwok in such boards and cabins.

Such means are:
i) an electro-optical element like a transducer suitable to modulate the attenuation of a light beam that passes through the element when a voltage is applied to the element;
ii) a suitable light source to generate the light beam that passes through said electro-optical element;
iii) a detector suitable to convert said optical signal into an electric signal;
iv) at least one optical fiber which connects between them the light source, the electro-optical element and the detector;
   where:
   - the light source is a laser or LED type for telecommunication systems;
   - the detector is a conventional photodiode, located in a remote position, of the type in use in telecommunications;
   - the optical fiber is single mode or multimode fiber of the type used for telecommunications.

In the device described above the electro-optical element is made of an electro-optic material sensitive to the electric voltage applied.The optical signal that passes through said element is then detected by a photo detector that converts it into an electric signal, the latter is acquired and processed by means of a suitable software suitable to generate an optical signal synchronous with the applied network voltage.

This synchronous signal can be acquired and processed locally and then sent to a control room via wireless transmission, but preferably it is sent on optical fiber and processed at a distance.

As an alternative to some of the above items the following elements are used:
- an electro-optical element suitable to be crossed twice by the same light beam retroreflected by a mirror or other reflective element.This configuration doubles the sensitivity of the device with respect to said transducer;
- a single optical fiber to launch and collect the luminous signal;
- the optical source has a wavelength suitable to be transmitted by the optical fiber used: for instance, for the optical fibers normally used for the telecommunications, the wavelength can be conveniently placed around 1,550 nm or 1,320 nm.

### Advantages of the invention

The invention solves and overcomes the problems and limitations of the state of the art, in particular, it allows to detect the presence of voltage in an electric board or in an electric cabin and send to distance an optical signal containing the information about the phase, the polarity of the electric voltage detected as well as of its amplitude.

In particular, it is understood that using three devices invented there is the additional advantage of controlling the three phases of the electric network under monitoring, ie. detect the relative phase relationship and any faults in the network that induce an abnormal phase shift.

Also, this device is suitable to provide an optical signal of synchronism, free from interferences and electromagnetic disturbances, to diagnostic means capable of early detecting in electric components (such as in the operation compartments of distribution cabins) the occurrence of phenomena due to a deterioration of the electric insulation ccaused by partial discharges or predischarges in air as well as to identify the nature thereof taking advantage of the characteristics of these phenomena that are indeed correlated with the phases and the polarity of the network voltage.

A further advantage is that the device ensures full galvanic isolation between the monitored apparatus and the measuring equipment.

Furthermore, the device is insensitive to external disturbing electromagnetic fields, thus being suitable for use in environments in which various electric apparatuses operate.

Finally, the device is capable of measuring continuously the value of the voltage, phase and polarity of the electric signal, from which it is possible to derive the synchronism signal relevant to the monitored electric phase.

There are then to point out the following other advantages.

The described device can be housed inside containers compatible with those used for signal lights having the same electric connections.

The installation of such containers in MV boards is made therefore without any changes therein and ensures compliance with the existing regulations.

The connection via optical fibers, in addition to ensuring the galvanic isolation, does not require any type of power supply for the measuring device.

### Detailed description of the invention.

The invention will now be described in more detail with an example of embodiment and the aid of the drawing in which:
- Fig.1 is a first electric diagram,
- Fig 2 is a whole view,
- Fig 3 is a second electric diagram and
- Figs. 4 and 5 are two diagrams.

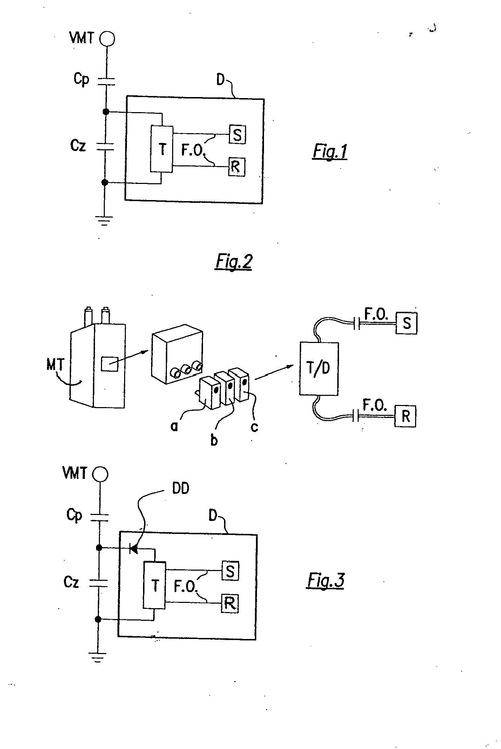

Figure 1 shows an optical device D that generates a synchronism signal relevant to one of three electric phases: the electro-optical element in the form of an optical transducer T is inserted inside one of the three modules of light-signaling the phase presence (there will be a transducer for each of the electric phases) and is connected to the network voltage.With S it is shown the light source, with R the detector of optical signals in optical fiber (FO), with VMT the voltage of the electric phase, with Cp the capacity divider, and with Cz the caapacity ballast. The optical transducer T is in voltage-sensitive electro-optical material, such as a transparent ceramic sensitive to the intensity of the electric field through an electro-optical effect of the second order, known as the Kerr effect. The source S and the detector R are located in a remote control board and the connection with the optical transducer T is made via the optical fiber FO.

Figure 2 shows the location of a device D, with its optical transducer T, inserted in the module c, one of the three modules a, b, c, installed within a framework MT.

Figure 3 similar to Figure 1, shows that within a module is inserted a diode DD which eliminates one of the two polarities of the current applied in order to unambiguously determine the polarity of the signal.

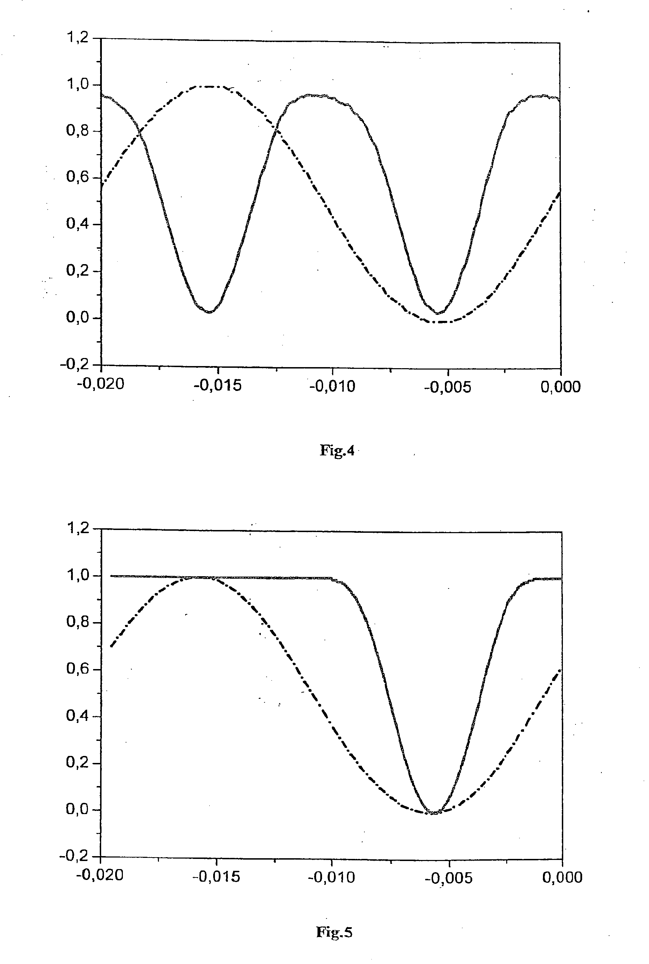

Figure 4 is an example of measurement in the configuration shown in fig. 1: with a dashed line the curve is visible which shows the voltage applied to the device and with continuous line the synchronism signal is visible as obtained by the optical device D. In abscissas are the times in seconds and in ordinates the normalized signals in synchronism in u.a. (arbitrary units) and the voltages in volts.

Figure 5 is an example of measurement in the configuration shown in Fig 3; with a dashed line the curve is vibisible of the applied voltage and with continuous line the synchronism signal derived from the device after introducing the diode DD for discriminating the polarity of the voltage. In abscissas are the times in seconds and the ordinates the normalized signals in synchronism in u.a. and the tensions in volts.

## Claims

1. Device suitable for generating a signal synchronous with the voltage of one phase of an electric network in order to continuously monitor the presence and the variation of the netwwork voltage in an electrical cabin or in an electric board, **characterized in that** the device comprises an electro-optical transducer (T ) suitable to generate an optical signal that has the same frequency and phase of the voltage of the electric network, synchronous with the voltage of a predetermined phase in a remote control board or in a remote electric cabin of an electric network.

2. Device according to claim 1 **characterized in that** the electro-optical transducer (T), inserted inside one of the three modules of the luminous indicator of phase presence, is connected with the network voltage and, by means of optical fibers (FO), with a detector (R) adapted to convert said optical signal into an electrical signal, a light source (S) being adapted to generate the light beam that passes through the electro-optic transducer (T);

3. Device (D) according to claim 1 **characterized in that**:
i) the electro-optical transducer (T) modulates the attenuation of the light beam that passes through it (T) when an electric voltage is applied to the latter (T);
ii) the light source (S) generates the light beam that passes through said electro-optical transducer (T);
iii) the detector (R) converts said optical signal into an electric signal;
iv) at least one optical fiber (FO) mutually connects the light source (S) and the electro-optical transducer (T);
Where:
- The light source (S) is a laser or LED for telecommunications systems;
- The detector (R) is a conventional photodiode of the type currently in use in telecommunications;
- The optical fiber (FO) is single mode or multimode of the type used for telecommunication.

4. Device (D) according to claims 1-3 **characterized in that** it comprises a diode (DD) which allows to eliminate one of the two polarities of the electric voltage applied in order to determine unequivocally the polarity of the voltage.

5. Device (D) according to claims 1-4 **characterized in that**
- The electro-optical element (T) is suitable to be crossed twice by the same beam of light retroreflected by a reflective element to duplicate the sensitivity of the device.
- A single optical fiber (FO) is used to launch and collect the light beam;
- The light source (S) has a wavelength suitable to be transmitted by the optical fiber (FO) used.

6. Device (D) according to claims 1-5 **characterized in that** it is suitable to be mounted inside a luminous indicator of the presence of phase or directly on a capacitive divider inside an electrical board.
